# EUROPÄISCHE PATENTSCHRIFT

(11) **EP 1 428 224 B1**
(45) Veröffentlichungstag und Bekanntmachung des Hinweises auf die Patenterteilung: **09.02.2005**
(21) Anmeldenummer: 03722257.7
(22) Anmeldetag: 03.04.2003
(51) Int. Cl.: G11C 27/02

(54) **INTEGRIERTE SCHALTUNG MIT EINER ABTAST-HALTE-EINRICHTUNG**
INTEGRATED CIRCUIT WITH A SAMPLE-AND-HOLD DEVICE
CIRCUIT INTEGRE EQUIPE D'UN DISPOSITIF D'INTERROGATION ET DE MAINTIEN

(30) Priorität: 30.04.2002 DE 10219327
(43) Veröffentlichungstag der Anmeldung: 16.06.2004
(73) Patentinhaber: Infineon Technologies AG, 81669 München (DE)
(72) Erfinder: BOGNER, Peter, A-9500 Villach (AT)
(74) Vertreter: Epping Hermann & Fischer
(86) Internationale Anmeldenummer: PCT/DE2003/001106
(87) Internationale Veröffentlichungsnummer: WO 2003/094172

(56) Entgegenhaltungen:
- WO-A-92/09990
- US-A- 5 493 246
- US-A- 5 506 526
- US-A- 5 959 565

## Beschreibung

Die Erfindung bezieht sich auf eine integrierte Schaltung mit einer Abtast-Halte-Einrichtung.

Eine solche integrierte Schaltung kann beispielsweise als Analog-Digital-Wandler ausgebildet sein, wobei die Abtast-Halte-Einrichtung häufig der kritische Teil des Analog-Digital-Wandlers ist. Wenn die Abtast-Halte-Einrichtung eine kapazitive Speichereinrichtung zum Halten eines Abtastwertes aufweist, begrenzt einerseits die Ladezeit der kapazitiven Speichereinrichtung die mögliche Taktfrequenz (Zyklen von Abtast- und Haltephase pro Zeit) des Analog-Digital-Wandlers und können andererseits von einer vorherigen Abtastung noch Restladung in der kapazitiven Speichereinrichtung vorhanden sein, was zu Fehlern bei der Analog-Digital-Wandlung führt. Hängt die Restladung von einer durchzuführenden Digital-Analog-Wandlung ab, treten sogenannte intersymbolische Interferenzen auf. Solche Fehler treten insbesondere bei Analog-Digital-Wandler-Architekturen auf, bei denen ein in Abhängigkeit der Analog-Digital-Wandlung des Abtastwerts bestimmter Wert zum Abtastwert addiert bzw. subtrahiert wird, wie dies beispielsweise bei der Pipeline-Architektur und der ZweiSchritt Flash-Architektur durchgeführt wird.

US 5.959.566 beschreibt eine Abtust-Halte-Einrichtung in der die kapazitive Speichereinrichtung kurzgeschlossen wird um Restladungen zu entfernen.

Ausgehend hiervon ist es Aufgabe der vorliegenden Erfindung, eine integrierte Schaltung mit einer Abtast-Halte-Einrichtung bereitzustellen, bei der der Einfluß eines vorhergehenden Zyklus auf einen nachfolgenden Zyklus minimiert bzw. ausgelöscht werden kann.

Erfindungsgemäß wird die Aufgabe durch eine integrierte Schaltung mit einer Abtast-Halte-Einrichtung gelöst, bei der die Abtast-Halte-Einrichtung eine Eingangsstufe (z. B. Verstärker oder Puffer) mit einem Eingang, an den ein analoges Eingangssignal anlegbar ist, und einem Ausgang, eine erste kapazitive Speichereinrichtung, eine Rücksetzeinrichtung (bzw. Kompensationseinrichtung) sowie eine Schalteinrichtung aufweist, wobei die Abtast-Halte-Einrichtung in aufeinanderfolgenden Zyklen mit jeweils einer Abtastphase und einer Haltephase betreibbar ist, wobei die Schalteinrichtung in der Abtastphase die erste Speichereinrichtung mit dem Ausgang der Eingangsstufe verbindet, um in der ersten Speichereinrichtung einen zum angelegten Eingangssignal proportionalen Spannungswert zu speichern, und in der Haltephase die erste Speichereinrichtung vom Ausgang der Eingangsstufe trennt, um den gespeicherten Spannungswert für einen weiteren Schaltungsteil der integrierten Schaltung bereitzustellen, so daß die erste Speichereinrichtung am Ende der Haltephase einen Endspannungswert speichert, wobei die Rücksetzeinrichtung (bzw. Kompensationseinrichtung) eine zweite kapazitive Speichereinrichtung mit gleicher Kapazität wie die erste Speichereinrichtung sowie eine Steuerschaltung aufweist, wobei die Steuerschaltung ein Laden der zweiten Speichereinrichtung während eines ersten Zyklus auf einen Spannungswert bewirkt, der zum Endspannungswert bezüglich einer Referenzspannung invertiert ist, und in der Abtastphase des auf den ersten Zyklus folgenden zweiten Zyklus die zweite Speichereinrichtung mit der ersten Speichereinrichtung verbindet, um die erste Speichereinrichtung zu entladen bzw. auf einen signalunabhängigen vorbestimmten Wert zu laden.

Bei der erfindungsgemäßen integrierten Schaltung erfolgt aufgrund des Verbindens der beiden Speichereinrichtungen ein Ladungsausgleich zwischen der ersten und zweiten Speichereinrichtung in der Abtastphase des zweiten Zyklus, so daß unabhängig vom Endspannungswert der ersten Speichereinrichtung am Ende der Haltephase des ersten Zyklus ein definierter Ausgangszustand erzeugt wird, weshalb die Eingangsstufe immer die gleiche Vorladung sieht. Dabei wird die Entladung der ersten Speichereinrichtung durch das Verbinden mit der zweiten Speichereinrichtung in der Abtastphase (bevorzugt zu Beginn der Abtastphase) des zweiten Zyklus bewirkt, so daß keine separate Entladungsphase vorgesehen werden muß, die nachteilig die Zeit bis zur nächsten Abtastphase verlängern würde. Es findet also ein Entladen der zweiten Speichereinrichtung während der Abtastphase statt, so daß die Abtast-Halte-Einrichtung mit hoher Taktfrequenz betrieben werden kann und dabei sichergestellt wird, daß keine Restladung eines vorhergehenden Abtastwertes des ersten Zyklus die Abtastung im zweiten Zyklus nachteilig beeinflußt. Damit werden auch die intersymbolischen Interferenzen verhindert.

Die Zyklen werden bevorzugt unmittelbar nacheinander durchgeführt, wodurch wiederum eine hohe Taktfrequenz ermöglicht wird, wobei ein Entladen der ersten Speichereinrichtung in jedem Zyklus durch Verbinden mit der im jeweils vorhergehenden Zyklus entsprechend vorgeladenen zweiten Speichereinrichtung durchgeführt werden kann.

Die Eingangsstufe kann ein Eingangsknoten oder auch ein Treiber (z.B. ein Differenzverstärker oder Operationsverstärker) sein.

In einer vorteilhaften Ausgestaltung der erfindungsgemäßen integrierten Schaltung beaufschlagt die Steuerschaltung zum Laden der zweiten Speichereinrichtung die zweite Speichereinrichtung während der Abtastphase des ersten Zyklus mit einer Spannung, die zu einer Spannung, mit der die erste Speichereinrichtung während der Abtastphase beaufschlagt wird, bezüglich der Referenzspannung invertiert ist. Dadurch wird schon während der Abtastphase die zweite Speichereinrichtung auf den gewünschten Spannungswert geladen (wenn sich die Endspannung der ersten Speichereinrichtung während der Haltephase nicht ändert), so daß die Entladung (bzw. das Laden auf den vorbestimmten Wert) während der Abtastphase des zweiten Zyklus sicher durchgeführt werden kann.

Insbesondere kann bei der erfindungsgemäßen integrierten Schaltung die Steuerschaltung zum Laden der zweiten Speichereinrichtung die zweite Speichereinrichtung während der Haltephase des ersten Zyklus mit einer Spannung beaufschlagen, die zu einer Spannung, mit der die erste Speichereinrichtung während der Haltephase beaufschlagt wird, bezüglich der Referenzspannung invertiert ist. Dies ist besonders vorteilhaft bei der Ausbildung der integrierten Schaltung als Analog-Digital-Wandler, bei dem in der Haltephase zum gehaltenen Spannungswert noch ein Spannungswert addiert wird, wie z.B. ein Digital-Analog-Wert, wie dies insbesondere bei Analog-Digital-Wandlern mit Pipeline-Architektur (wie z.B. in A. Abo et al., "A 1.5-V, 10-bit, 14.3-MS/s CMOS Pipeline Analog-to-Digital Converter", IEEE Journal of Solid-State Circuits,_ Band 34, Nr. 5, S. 599-606, Mai 1999 beschrieben ist) oder Zwei-Schritt Flash-Architektur der Fall ist. Somit wird auch in diesem Fall das Entladen der ersten Speichereinrichtung (bzw. das Laden auf den vorbestimmten Wert) während der Abtastphase des zweiten Zyklus gewährleistet.

Ferner kann bei der erfindungsgemäßen integrierten Schaltung die Steuerschaltung ein Laden der zweiten Speichereinrichtung während des zweiten und der nachfolgenden Zyklen jeweils auf einen Spannungswert bewirken, der zum Endspannungswert der ersten Speichereinrichtung dieses Zyklus bezüglich der Referenzspannung invertiert ist, und kann die Steuerschaltung in der Abtastphase des dritten bzw. der weiteren Zyklen die weitere Speichereinrichtung mit der ersten Speichereinrichtung verbinden. Dadurch wird sichergestellt, daß in den Abtastphasen der zweiten und weiteren Zyklen die erste Speichereinrichtung jeweils entladen wird, so daß die Eingangsstufe jeweils die gleiche Vorladung in der Abtastphase sieht.

Des weiteren können bei der integrierten Schaltung die erste und die zweite Speichereinrichtung jeweils einen Kondensator aufweisen, die beim Verbinden in der Abtastphase des zweiten Zyklus und bevorzugt auch der weiteren Zyklen parallel geschaltet werden. Durch diese Ausgestaltung ist eine Verwirklichung der ersten und zweiten Speichereinrichtung besonders einfach möglich.

Weiterhin können die erste und zweite Speichereinrichtung jeweils mehrere, während der Abtastphase parallel geschaltete Kondensatoren aufweisen, wobei jedem Kondensator der ersten Speichereinrichtung ein Kondensator der zweiten Speichereinrichtung für einen Zyklus zugeordnet ist. Jedes dieser Kondensatorenpaare wird im vorhergehenden Zyklus in der beschriebenen Weise auf zueinander invertierte Spannung bezüglich der Referenzspannung geladen, so daß ein Verbinden (Parallelschalten) der Kondensatorenpaare während der Abtastphase des Zyklus zu dem gewünschten Entladen führt. Die Zuordnung der Kondensatoren kann einerseits für alle Zyklen oder andererseits nur für geradzahlige und ungeradzahlige Zyklen gleich sein.

Die erfindungsgemäße integrierte Schaltung kann insbesondere als (bevorzugt mehrstufiger) Digital-Analog-Wandler ausgebildet sein. Damit wird ein Analog-Digital-Wandler bereitgestellt, mit dem sehr hohe Taktfrequenzen realisiert werden können.

Eine besondere Ausbildung der erfindungsgemäßen integrierten Schaltung besteht darin, daß die erste Speichereinrichtung einen ersten und zweiten Kondensator, die zweite Speichereinrichtung einen dritten und vierten Kondensator umfaßt, wobei der erste und der dritte Kondensator sowie der zweite und der vierte Kondensator jeweils die gleiche Kapazität aufweisen, wobei die Eingangsstufe einen Differenzverstärker umfaßt, an dem ein (bevorzugt differentielles) analoges Eingangssignal anlegbar ist und dessen Ausgang einen invertierenden und einen nicht-invertierenden Ausgangsanschluß aufweist, wobei die Schalteinrichtung in der Abtastphase den ersten Kondensator mit dem nicht-invertierenden Ausgangsanschluß und den zweiten Kondensator mit dem invertierenden Ausgangsanschluß verbindet, wobei die Steuerschaltung zum Laden während des ersten Zyklus bewirkt, daß der dritte Kondensator auf einen Spannungswert, der zum Endspannungswert des ersten Kondensators bezüglich der Referenzspannung invertiert ist, und der vierte Kondensator auf einen Endspannungswert geladen werden, der zum Endspannungswert des zweiten Kondensators bezüglich der Referenzspannung invertiert ist, und wobei in der Abtastphase des zweiten Zyklus die Steuerschaltung den ersten Kondensator mit dem dritten Kondensator sowie den zweiten Kondensator mit dem vierten Kondensator verbindet.

Damit kann die erfindungsgemäße integrierte Schaltung auch als integrierte Schaltung mit einer volldifferentiell ausgebildeten Abtast-Hälte-Einrichtung bereitgestellt werden, wobei die beschriebenen Vorteile auch bei der volldifferentiellen Ausführungsform verwirklicht sind. Insbesondere werden bei der volldifferentiellen Ausführung der integrierten Schaltung die benötigten invertierten Spannungen schon bereitgestellt, so daß die schaltungstechnische Realisierung besonders einfach ist.

Besonders bevorzugt kann bei der erfindungsgemäßen integrierten Schaltung die Steuerschaltung in Abtastphasen von geradzahligen Zyklen den dritten Kondensator parallel zum ersten Kondensator sowie den vierten Kondensator parallel zum zweiten Kondensator schalten und in Abtastphasen von ungeradzahligen Zyklen den dritten Kondensator parallel zum zweiten Kondensator sowie den vierten Kondensator parallel zum ersten Kondensator schalten. In diesem Fall weisen alle vier Kondensatoren bevorzugt den gleichen Kapazitätswert auf. Dies stellt eine besonders einfache Verwirklichung der erfindungsgemäßen integrierten Schaltung insbesondere für den Fall dar, bei dem die gespeicherten Spannungswerte auf dem ersten und zweiten Kondensator während der Haltephase nicht verändert werden.

Ferner kann bei der erfindungsgemäßen integrierten Schaltung die erste und zweite Speichereinrichtung jeweils die gleiche Anzahl von während der Abtastphase parallel geschalteten Kondensatoren mit gleicher Kapazität aufweisen. Damit lassen sich einerseits leicht hohe Kapazitätswerte realisieren und andererseits können mehrstufige Analog-Digital-Wandler realisiert werden, bei denen jede Stufe mehrere Bits des zu erzeugenden digitalisierten Werts ausgeben kann.

Ferner wird die Aufgabe auch durch eine integrierte Schaltung mit einer Abtast-Halte-Einrichtung gelöst, bei der die Abtast-Halte-Einrichtung eine Eingangsstufe mit einem Eingang, an den ein analoges Eingangssignal anlegbar ist, und einem Ausgang, eine erste induktive Speichereinrichtung, eine Rücksetzeinrichtung sowie eine Schalteinrichtung umfaßt, wobei die Abtast-Halte-Einrichtung in aufeinanderfolgenden Zyklen mit jeweils einer Abtastphase und einer Haltephase betreibbar ist, wobei die Schalteinrichtung in der Abtastphase die erste Speichereinrichtung mit dem Ausgang der Eingangsstufe verbindet, um in der ersten Speichereinrichtung einen zum angelegten Eingangssignal proportionalen Stromwert zu speichern, und in der Haltephase die erste Speichereinrichtung vom Ausgang der Eingangsstufe trennt, um den gespeicherten Stromwert für einen weiteren Schaltungsteil der integrierten Schaltung bereitzustellen, so daß die erste Speichereinrichtung am Ende der Haltephase einen Endstromwert speichert, wobei die Rücksetzeinrichtung eine zweite induktive Speichereinrichtung mit gleicher Induktivität wie die erste Speichereinrichtung sowie eine Steuerschaltung aufweist, wobei die Steuerschaltung ein Laden der zweiten Speichereinrichtung während eines ersten Zyklus auf einen Stromwert bewirkt, der zum Endstromwert bezüglich eines Referenzstroms invertiert ist, und in der Abtastphase des auf den ersten Zyklus folgenden zweiten Zyklus die zweite Speichereinrichtung mit der ersten Speichereinrichtung verbindet, um die erste Speichereinrichtung zu entladen bzw. auf einen signalunabhängigen vorbestimmten Wert zu laden.

Mit dieser erfindungsgemäßen integrierten Schaltung wird effektiv verhindert, daß die Abtastung während eines Zyklus durch den Abtastwert bzw. den Endstromwert im vorherigen Zyklus beeinflußt wird.

Die erfindungsgemäße integrierte Schaltung mit der Abtast-Halte-Einrichtung, die induktive Speichereinrichtungen aufweist, kann in gleicher Weise, wie bezüglich der erfindungsgemäßen integrierten Schaltung mit der Abtast-Halte-Einrichtung, die die kapazitiven Speichereinrichtungen aufweist, beschrieben wurde, weitergebildet werden, wobei anstatt von Kondensatoren Induktivitäten und anstatt von Spannungswerten Stromwerte gespeichert werden.

Die Erfindung wird nachfolgend anhand der Zeichnungen im Prinzip beispielshalber noch näher erläutert. Es zeigen:
- Fig. 1: ein schematisches Schaltbild einer Ausführungsform der erfindungsgemäßen integrierten Schaltung;
- Fig. 2: ein schematisches Schaltbild einer Stufe der in Fig. 1 gezeigten integrierten Schaltung;
- Fig. 3: eine andere Ausführung einer Stufe der integrierten Schaltung von Fig. 1, und
- Fig. 4: ein schematisches Schaltbild einer weiteren Ausführungsform einer Abtast-Halte-Einrichtung.

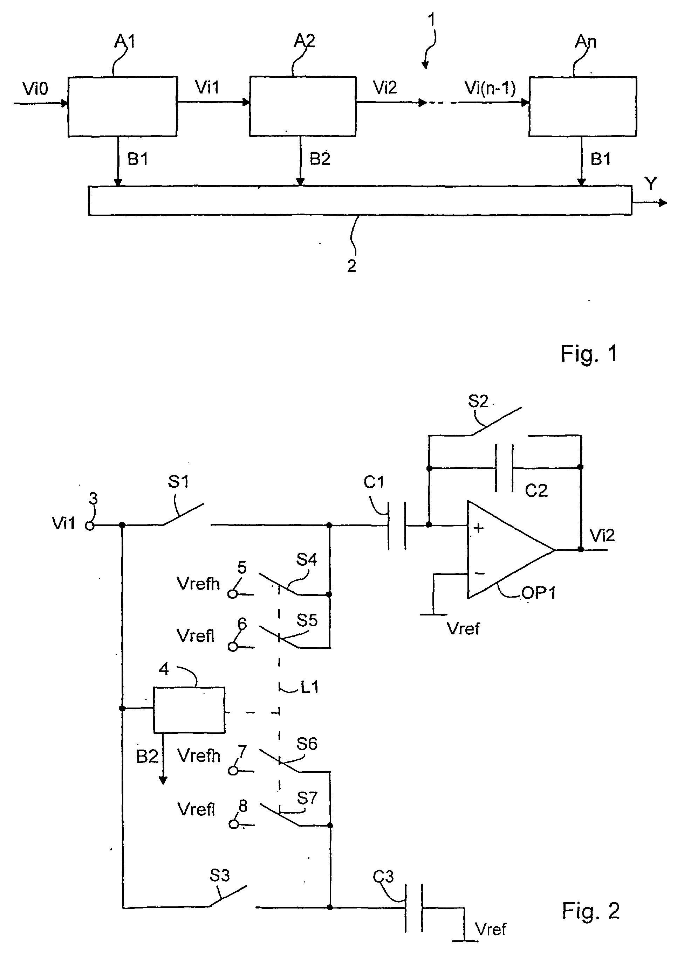

In Fig. 1 ist als Beispiel der erfindungsgemäßen integrierten Schaltung ein Analog-Digital-Wandler 1 mit einem Pipeline-Aufbau gezeigt. Der Analog-Digital-Wandler 1 zum Wandeln einer analogen Eingangsspannung Vi0 in einen Digitalwert Y mit m Bits enthält n hintereinander geschaltete Stufen A1, A2, ... An, die jeweils einen Binärwert B1, B2, ... Bn mit einem oder mehreren Bits für den Digitalwert Y erzeugen und an eine Digitaleinheit 2 anlegen, die den gewünschten Digitalwert Y ausgibt. Die einzelnen Bits B1, B2, ... Bn werden dabei zeitlich nacheinander erzeugt, wobei die erste Stufe A1 aus dem anliegenden Analogwert Vi0 den Bitwert B1 erzeugt und an die Digitaleinheit 2 ausgibt und einen in bekannter Weise verarbeiteten Analogwert Vi1 an die zweite Stufe A2 anlegt. Dies wird so lang fortgesetzt, bis auch die letzte Stufe An den entsprechenden Bitwert Bn an die Digitaleinheit 2 ausgibt, die dann den Digitalwert Y erzeugen kann.

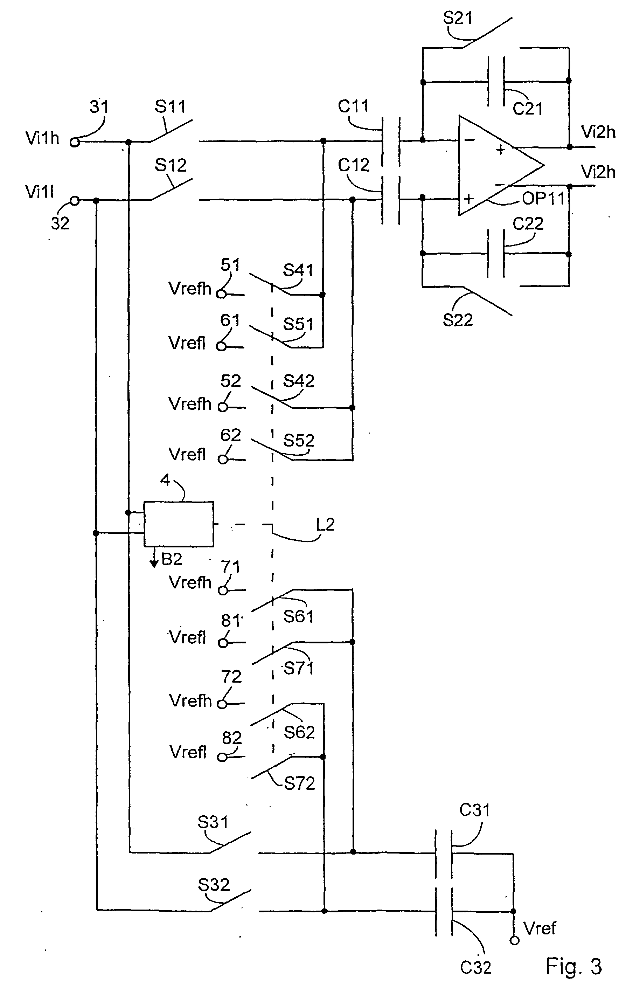

In Fig. 2 ist stellvertretend für den Aufbau der Stufen A1 bis An die zweite Stufe A2 detaillierter dargestellt. An einem Eingangsknoten 3 liegt die analoge Eingangsspannung Vi1 der ersten Stufe A1 an. Der erste Knoten 3 ist über einen ersten Schalter S1 mit einem ersten Anschluß eines Speicherkondensators C1 verbunden, dessen zweiter Anschluß an einem nicht-invertierenden Eingang eines Differenzverstärkers (bzw. Operationsverstärker) OP1 angeschlossen ist. Der nicht-invertierende Eingang des Differenzverstärkers OP1 ist über einen Rückkopplungskondensator C2 mit dem Ausgang des Differenzverstärkers OP1 verbunden, wobei ein zweiter Schalter S2 parallel zum Rückkopplungskondensator C2 geschaltet ist. Der invertierende Eingang des Differenzverstärkers OP1 liegt auf einem vorbestimmten Referenzpotential Vref (hier 0 Volt).

Der erste Knoten 3 ist ferner mit einer nur schematisch dargestellten Analog-Digital-Wandlereinheit 4 verbunden, so daß an der Analog-Digital-Wandlereinheit 4 auch die analoge Eingangsspannung Vi1 anliegt. Im Betrieb gibt die Analog-Digital-Wandlereinheit 4 den Binärwert B2 aus.

Ferner ist der erste Knoten 3 über einen dritten Schalter S3 mit einem Anschluß eines Rücksetzkondensators (bzw. Kompensationskondensator) C3 verbunden, wobei der andere Anschluß des Rücksetzkondensators C3 auf dem gleichen Potential (Referenzpotential Vref) wie der invertierende Eingang des Differenzverstärkers OP1 liegt (hier 0 Volt).

Die Kapazität des Speicherkondensators C1 ist gleich groß wie die Kapazität des Rücksetzkondensators C3 und auch wie die Kapazität des Rückkopplungskondensators C2.

Der Speicherkondensator C1 kann über einen vierten Schalter S4 der zweiten Stufe A2 mit einem zweiten Knoten 5, der auf einem ersten Potential Vrefh (hier beispielsweise + 2 Volt) liegt, und über einen fünften Schalter S5 mit einem dritten Knoten 6, der auf einem zweiten Potential Vrefl (hier im Beispiel - 2 Volt) liegt, verbunden werden. Der Rücksetzkondensator C3 kann über einen sechsten Schalter S6 mit einem vierten Knoten 7, der auf dem ersten Potential Vrefh liegt, und über einen siebten Schalter S7 mit einem fünften Knoten 8, der auf dem zweiten Potential Vrefl liegt, verbunden werden.

Der vierte bis siebte Schalter S4 bis S7 werden in Abhängigkeit des Ergebnisses der Analog-Digital-Wandlereihheit 4 geöffnet und geschlossen, wie durch die gestrichelte Linie L1 angedeutet ist. Der erste bis dritte Schalter S1 bis S3 werden mittels einer nicht gezeigten Steuereinrichtung geöffnet und geschlossen. Die Schalter S1 bis S7, die Steuereinrichtung (nicht gezeigt) der Schalter S1 bis S3, die Analog-Digital-Wandlereinheit 4 und die Kondensatoren C1 und C3 bilden eine Abtast-Halte-Einrichtung der zweiten Stufe A2.

Im Betrieb des Analog-Digital-Wandlers 1 wird in jeder der Stufen A1, A2, ... An und somit auch in der zweiten Stufe A2, die in Fig. 2 gezeigt ist, während einer Abtastphase die anliegende analoge Spannung Vi0, Vi1, ... Vi(n-1) abgetastet. Bei der Stufe A2 liegt die Spannung Vi1 am ersten Knoten (Eingangsknoten) 3 an, wobei während der Abtastphase die Schalter S1, S2 und S3 jeweils geschlossen und die Schalter S4 bis S7 geöffnet sind. Am Ende der Abtastphase werden die Schalter S1 bis S3 geöffnet, so daß der zuletzt anliegende Analogwert der Spannung Vi1 im Speicherkondensator C1 gespeichert ist und auch am Rücksetzkondensator C3 anliegt, der während der Abtastphase parallel zum Speicherkondensator C1 geschaltet war. In dem hier beschriebenen Beispiel wird angenommen, daß die Spannung am Speicherkondensator C1 sowie am Rücksetzkondensator C3 jeweils 1,5 Volt beträgt.

In der nun folgenden Haltephase gibt die Analog-Digital-Wandlereinheit 4 den Binärwert B2 aus und schließt in Abhängigkeit der durchgeführten Analog-Digital-Wandlung selektiv die Schalter S4 und S5 um eine vorbestimmte Spannung zur gehaltenen (gespeicherten) Spannung des Speicherkondensators C1 zu addieren oder zu subtrahieren, wobei der Rest durch den Differenzverstärker OP1 verstärkt wird

Bei dem beschriebenen Beispiel wird angenommen, daß der Schalter S4 geschlossen wird. Dies hat zur Folge, daß der Speicherkondensator C1 auf das Potential Vrefh gezogen wird, da der nicht-invertierende Eingang des Differenzverstärkers OP1 auf Vref liegt und somit als virtuelle Masse wirkt. Am Ausgang des Differenzverstärkers OP1 wird dabei die gewünschte analoge Ausgangsspannung Vi2 erzeugt. Somit kann der Differenzverstärker OP1 als Eingangsstufe der dritten Stufe A3 (nicht gezeigt) betrachtet werden. Der Differenzverstärker OP1 kann auch weggelassen werden. In diesem Fall muß nur dafür gesorgt werden, daß die zweiten Anschlüsse des Speicher- und des Rücksetzkondensators C1 und C3 auf dem gleichen Potential liegen.

Andererseits wird der Schalter S7 geschlossen, so daß der Rücksetzkondensator C3 auf Vrefl gezogen wird. Am Ende der Abtastphase werden die Schalter S4 und S7 wieder geöffnet, so daß der Speicherkondensator C1 und der Rücksetzkondensator C3 auf zueinander invertierte Spannungen zum Referenzpotential Vref sind.

Die Schalter S5 bis S8 werden also immer so betätigt, daß am Ende der Abtastphase die Kondensatoren C1 und C3 auf zueinander invertierten Spannungen liegen.

Diese beschriebene Abtast- und Haltephase werden laufend hintereinander durchgeführt, so daß in der nun folgenden Abtastphase, wenn die Schalter S1 bis S3 wieder geschlossen werden, ein Ladungsausgleich zwischen dem Speicherkondensator C1 und dem Rücksetzkondensator C3 erfolgt, so daß beide Kondensatoren C1 und C3 entladen werden (bzw. die miteinander verbundenen Anschlüsse der Kondensatoren C1 und C3 liegen auf der Referenzspannung Vref (hier 0 Volt)). Alternativ können die beiden Kondensatoren C1 und C3 bei geeigneter Wahl von Vref auch in jeder Abtastphase auf einen signalunabhängigen vorbestimmten Wert (der von 0 Volt verschieden, aber in jeder Abtastphase gleich ist) geladen werden. Damit wird ein definierter Ausgangszustand zu Beginn der Abtastphase erzeugt, wobei dazu keine eigene Rücksetzphase vor der Abtastphase benötigt wird. Dadurch wird erreicht, daß der Abtastwert bzw. der Spannungswert, auf dem Speicherkondensator C1 am Ende der vorherigen Haltephase ist, keinen Einfluß auf die nachfolgende Abtastphase hat. Somit werden die sogenannten intersymbolischen Interferenzen vermieden.

In Fig. 3 ist eine Ausführungsform der zweiten Stufe A2 für den Fall der volldifferentiellen Ausbildung des Analog-Digital-Wandlers von Fig. 1 gezeigt. Eingangsseitig weist daher die zweite Stufe zwei Eingangsknoten 31 und 32 auf, an denen die beiden Komponenten Vi1h und Vi1l der analogen Eingangsspannung Vi1 anliegen, wobei die Komponenten zueinander bezüglich einem Referenzpotential Vref (hier z.B. 2,5 V) invertiert sind.

Der Eingangsknoten 31 ist über einen Schalter S11 mit einem ersten Anschluß eines ersten Speicherkondensators C11 verbindbar, wobei der zweite Anschluß des ersten Speicherkondensators C11 mit einem invertierenden Eingang eines Differenzverstärkers (Operationsverstärkers) OP11 verbunden ist. Der invertierende Eingang des Differenzverstärkers 11 ist über einen ersten Rückkopplungskondensator C21 mit dem nicht-invertierenden Ausgang des Differenzverstärkers OP11 verbunden, wobei ein Schalter S21 parallel zum ersten Rückkopplungskondensator C21 geschaltet ist.

In gleicher Weise ist der zweite Eingangsknoten 32 über einen Schalter S12 mit einem ersten Anschluß eines zweiten Speicherkondensators C12 verbindbar. Der zweite Anschluß des zweiten Speicherkondensators C12 ist mit dem nicht-invertierenden Eingang des Differenzverstärkers OP11 verbunden. Der nicht-invertierende Eingang des Differenzverstärkers OP11 ist über einen zweiten Rückkopplungskondensator C22 mit dem invertierenden Ausgang des Differenzverstärkers OP11 verbunden, wobei zum zweiten Rückkopplungskondensator C22 noch ein Schalter S22 parallel geschaltet ist.

Die Eingangsknoten 31 und 32 sind mit der Analog-Digital-Wandlereinheit 4 verbunden, die die Analog-Digital-Wandlung durchführt und den Binärwert B2 ausgibt.

Die zweite Stufe A2 enthält ferner einen ersten und einen zweiten Rücksetzkondensator C31 und C32, wobei der erste Anschluß des ersten Rücksetzkondensators C31 über einen Schalter S31 mit dem ersten Eingangsknoten 31 und der erste Anschluß des zweiten Rücksetzkondensators C32 über einen Schalter S32 mit dem zweiten Eingangsknoten 32 verbunden werden kann. Die zweiten Anschlüsse der beiden Rücksetzkondensatoren C31, C32 liegen auf dem Referenzpotential Vref (hier 2,5 V), das der Gleichtaktspannung des Differenzverstärkers OP11 entspricht. Die Speicherkondensatoren C11, C12, die Rücksetzkondensatoren C31 und C32 sowie die Rückkopplungskondensatoren C21 und C22 weisen jeweils den gleichen Kapazitätswert auf.

Alternativ können die beiden Speicherkondensatoren C11 und C12 unterschiedliche Kapazitätswerke aufweisen. In diesem Fall weist dann der Rücksetz- bzw. Kompensationskondensator C31 den gleichen Kapazitätswert wie der Speicherkondensator C11 auf und der Kapazitätswert des Rücksetz- bzw. Kompensationskondensators C32 entspricht dem des Speicherkondensators C12.

Der erste Anschluß des ersten Speicherkondensators C11 kann über einen Schalter S41 mit einem auf einem ersten Potential Vrefh (hier z.B. 4 V) liegenden Knoten 51 und über einen Schalter S51 mit einem auf einem zweiten Potential Vref1 (hier z.B. 1 V) liegenden Knoten 61 verbunden werden. Das erste Potential Vrefh ist zum zweiten Potential Vrefl bezüglich dem Referenzpotential invertiert. In gleicher Weise kann der erste Anschluß des zweiten Speicherkondensators C12 über einen Schalter S42 mit einem Knoten 52, der auf dem ersten Potential Vrefh liegt, und über einen Schalter S52 mit einem Knoten 62 verbunden werden, der auf dem zweiten Potential Vrefl liegt.

Der erste Anschluß des ersten Rücksetzkondensators C31 kann über einen Schalter S61 mit einem Knoten 71, der auf dem ersten Potential Vrefh liegt, und über einen Schalter S71 mit einem Knoten 81 verbunden werden, der auf dem zweiten Potential Vrefl liegt. In gleicher Weise kann der erste Anschluß des zweiten Rücksetzkondensators C32 mittels einem Schalter S62 mit einem Knoten 72, der auf dem ersten Potential Vrefh liegt, und mittels einem Schalter S72 mit einem Knoten 82, der auf dem zweiten Potential Vrefl liegt, verbunden werden.

Die Schalter S41, S42, S51, S52, S61, S62, S71 und S72 werden in Abhängigkeit des Wandel-Ergebnisses der Analog-Digital-Wandlereinheit 4 geöffnet und geschlossen, wie durch die gestrichelte Linie L2 in Fig. 3 angedeutet ist.

Die Schalter S11, S12, S21, S22, ... S72, die Kondensatoren C11, C12, C31, C32, die Wandlereinheit 4 sowie eine Steuereinrichtung (nicht gezeigt) für die Schalter S11, S12, S21, S22, S31, S32 bilden eine Abtast-Halte-Einrichtung, wobei der Verstärker der vorhergehenden Stufe A1 auch als Eingangsstufe der Abtast-Halte-Einrichtung betrachtet werden kann.

Der Differenzverstärker OP11 kann auch weggelassen werden. In diesem Fall muß nur dafür gesorgt werden, daß die zweiten Anschlüsse der Speicher- und Rücksetzkondensatoren auf dem gleichen Potential liegen.

Im Betrieb des Analog-Digital-Wandlers 1 liegen an der zweiten Stufe A2 in der Abtastphase die analogen Spannungen Vi1h und Vi1l an, wobei in der Abtastphase die Schalter S11, S12, S21, S22, S31 und S32 geschlossen und die restlichen Schalter geöffnet sind. Am Ende der Abtastphase werden die Schalter S11, S12, S21, S22 sowie S31 und S32 geöffnet. Unter der Annahme, daß zu diesem Zeitpunkt die Spannung Vi1h 3V und die Spannung Vi1l 2 V waren, beträgt die Spannung am ersten Speicherkondensator 0,5 V (am zweiten Anschluß des ersten Speicherkondensators C11 liegt die Referenzspannung von 2,5 V an) und beträgt die Spannung am zweiten Speicherkondensator C12 -0,5 V. In gleicher Weise liegt am ersten Rücksetzkondensator C31 eine Spannung von 0,5 V an, während am zweiten Rücksetzkondensator C32 eine Spannung von -0,5 V anliegt.

In der auf die Abtastphase folgende Haltephase gibt die Analog-Digital-Wandlereinheit 4 den Binärwert B2 aus und steuert die Schalter S41, S42, ... S72 beispielsweise derart an, daß von diesen Schaltern die Schalter S41, S52, S71 sowie S62 geschlossen werden. Dies hat zur Folge, daß der erste Anschluß des ersten Speicherkondensators C11 mit dem ersten Potential Vrefh beaufschlagt wird, so daß der erste Speicherkondensator auf 1,5 V liegt und aufgrund der Rückkopplung über den Rückkopplungskondensator C21 am nicht-invertierenden Eingang des Differenzverstärkers OP11 in die gewünschte analoge Ausgangsspannung Vi2h erzeugt wird. Da auch der Schalter S52 geschlossen wird, wird der erste Anschluß des zweiten Speicherkondensators C12 mit dem zweiten Potential Vrefl beaufschlagt, so daß der zweite Speicherkondensator C12 eine Spannung von - 1,5 V aufweist und aufgrund der Rückkopplung über den Rückkopplungskondensator C22 am invertierenden Ausgang des Differenzverstärkers OP11 die gewünschte analoge Spannung Vi21 für die nächste Stufe A3 erzeugt wird.

Ferner wird während der Haltephase aufgrund des geschlossenen Schalters S71 der erste Anschluß des ersten Rücksetzkondensators C31 mit Vrefl beaufschlagt, so daß der erste Kondensator C31 eine Spannung von - 1,5 V speichert. Der zweite Rücksetzkondensator C32 speichert die dazu invertierte Spannung von 1,5 V bezüglich der Referenzspannung Vref, da der Schalter S62 geschlossen und somit der erste Anschluß des zweiten Rücksetzkondensators C32 mit Vrefh beaufschlagt wird. Am Ende der Abtastphase werden die Schalter S41, S52, S71 sowie S62 wieder geöffnet, so daß der erste Speicherkondensator C11 und der erste Rücksetzkondensator C31 zueinander invertierte Spannungen zum Referenzpotential Vref speichern sowie auch der zweite Speicherkondensator C12 und der zweite Rücksetzkondensator C32 zueinander invertierte Spannungen zum Referenzpotential Vref speichern.

Da die beschriebene Abtast- und Haltephase laufend hintereinander durchgeführt werden, findet in der nun folgenden Abtastphase, wenn die Schalter S11, S12, S21, S22, S31 sowie S32 geschlossen werden, ein Ladungsausgleich zwischen dem ersten Speicherkondensator C11 und dem ersten Rücksetzkondensator C31 sowie zwischen dem zweiten Speicherkondensator C12 und dem zweiten Rücksetzkondensator C32 statt, der dazu führt, daß sowohl die Speicher- als auch die Rücksetzkondensatoren C11, C12, C31, C32 entladen werden. Anders gesagt, die ersten Anschlüsse der Speicherkondensatoren und der Rücksetzkondensatoren werden aufgrund des Ladungsausgleiches auf das Referenzpotential Vref gebracht, so daß die Spannung an den Speicher- und Rücksetzkondensatoren C11, C12, C31, C32 jeweils 0 V beträgt.

Damit wird zu Beginn einer jeden Abtastphase ein definierter Ausgangszustand erzeugt, der unabhängig vom Ladungszustand der Speicherkondensatoren C11, C12 am Ende der vorhergehenden Haltephase ist. Diese Erzeugung des definierten Ausgangszustands für jede Abtastphase erfolgt dabei unmittelbar zu Beginn der Abtastphase selbst, so daß keine eigene Rücksetzphase notwendig ist, in der mittels zusätzlicher Schalter ein Entladen der Speicherkondensatoren erfolgt, was unnötige Zeit in Anspruch nehmen würde.

Die Zahlenwerte der Kondensatorspannungen bei der obigen Beschreibung beziehen sich auf den eingeschwungenen (quasistationären) Zustand. Die Funktion bzw. das Verhalten der beschriebenen Schaltungen ist für den dynamischen Fall entsprechend, so daß auch dann zu Beginn jeder Abtastphase ein definierter Ausgangszustand erzeugt wird.

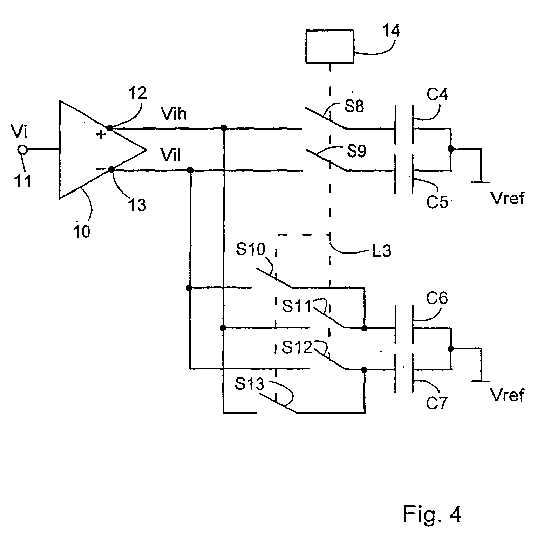

In Fig. 4 ist eine weitere Ausführungsform einer Abtast-Halteeinrichtung gezeigt, die volldifferentiell ausgebildet ist.

Die Abtast-Halte-Einrichtung enthält eine Treiber-Eingangsstufe 10 mit einem Eingangsanschluß 11, an dem eine analoge Eingangsspannung Vi anlegbar ist, und mit einem nicht-invertierenden Ausgangsanschluß 12 und einem invertierenden Ausgangsanschluß 13.

Der nicht-invertierte Ausgangsanschluß 12 ist über einen Schalter S8 mit einem ersten Anschluß eines ersten Speicherkondensators C4 verbunden, dessen zweiter Anschluß auf einem vorbestimmten Referenzpotential Vref (hier 0 V) liegt. Der invertierende Ausgangsanschluß 13 ist über einen Schalter S9 mit einem ersten Anschluß eines zweiten Speicherkondensators C5 verbunden, wobei der zweite Anschluß des zweiten Speicherkondensators C5 auf dem vorbestimmten Referenzpotential Vref liegt.

Weiterhin ist ein erster Rücksetzkondensator C6 vorgesehen, dessen erster Anschluß über einen Schalter S10 mit dem invertierenden Ausgangsanschluß 13 der Treiber-Eingangsstufe 10 und über einen Schalter S11 mit dem nicht-invertierenden Ausgangsanschluß 12 verbindbar ist. Der zweite Anschluß des ersten Rücksetzkondensators C6 liegt auf dem Referenzpotential Vref.

Ferner ist noch ein zweiter Rücksetzkondensator C7 vorgesehen, dessen erster Anschluß über einen Schalter S12 mit dem invertierenden Ausgangsanschluß 13 und über einen Schalter S13 mit dem nicht-invertierenden Ausgangsanschluß 12 der Treiber-Eingangsstufe 10 verbunden werden kann. Der Schalter S8 bis S13 werden mittels einer schematisch eingezeichneten Steuerschaltung 14 geöffnet und geschlossen.

Der erste Speicherkondensator C4, der zweite Speicherkondensator C5, der erste Rücksetzkondensator C6 sowie der zweite Rücksetzkondensator C7 weisen jeweils den gleichen Kapazitätswert auf.

Die Abtast-Halte-Einrichtung wird im Betrieb in aufeinanderfolgenden Zyklen mit jeweils einer Abtastphase und einer Haltephase betrieben.

In der Abtastphase eines ersten Zyklus werden mittels der Steuerschaltung 14 die Schalter S8, S9, S11 sowie S12 geschlossen und die Schalter S10 und S13 werden geöffnet. Somit liegt am ersten Speicherkondensator C4 und am ersten Rücksetzkondensator C6 eine analoge Spannung Vih an, die die Treiber-Eingangsstufe 10 bei eingangsseitiger anliegender Spannung Vi ausgibt, während am zweiten Speicherkondensator C5 und am zweiten Rücksetzkondensator C7 die von der Eingangs-Treiberstufe 10 ausgegebene analoge Spannung Vi1 anliegt. Am Ende der Abtastphase werden die Schalter S8, S9, S11 sowie S12 geöffnet, so daß die Spannung des ersten Speicherkondensators C4 gleich der Spannung des ersten Rücksetzkondensators C6 entspricht (hier z.B. + 4 V). Ferner entspricht die Spannung am zweiten Speicherkondensator C5 der Spannung am zweiten Rücksetzkondensator C7. In dem hier beschriebenen Ausführungsbeispiel ist dies - 4 V.

In der nun folgenden Haltephase können die in den Speicherkondensatoren C4 und C5 gespercherten Spannungen in weiteren Schaltungen bzw. Schaltungsteilen (nicht gezeigt) ausgewertet werden, wobei aber die Spannungen an den Speicherkondensatoren C4 und C5 selbst nicht oder nur geringfügig verändert werden. Alternativ werden die Spannungen an den Rücksetzkondensatoren entsprechend einer Änderung der Spannungen an den Speicherkondensatoren C4 und C5 geändert.

In der folgenden Abtastphase eines auf den ersten Zyklus folgenden zweiten Zyklus werden mittels der Steuerschaltung 14 die Schalter S8 und S9 sowie die Schalter S10 und S13 geschlossen. Dies hat zur Folge, daß ein Ladungsausgleich zwischen dem ersten Speicherkondensator C4, der in dem hier beschriebenen Beispiel auf + 4 V liegt, und dem zweiten Rücksetzkondensator C7, der auf - 4 v liegt, erfolgt, so daß beide Kondensatoren auf 0 V entladen werden. Das gleiche trifft für den zweiten Speicherkondensator C5 und den ersten Rücksetzkondensator C6 zu, die auch miteinander verbunden werden. Daher sind die Speicherkondensatoren C4 und C5 zu Beginn der Abtastphase entladen. Während der Abtastphase werden die beiden Speicherkondensatoren C4 und C5 und auch die beiden Rücksetzkondensatoren C6 und C7 auf jeweils zueinander invertierte Spannungen geladen. Nach der Abtastphase folgt wieder eine Haltephase und auf diese Haltephase folgt eine weitere Abtastphase, in der nun wiederum der erste Rücksetzkondensator C6 parallel zum ersten Speicherkondensator C4 sowie der zweite Rücksetzkondensator C7 parallel zum zweiten Speicherkondensator C5 geschaltet werden.

Somit ist für die Treiber-Eingangsstufe 10 bei jeder Abtastphase die gleiche Vorladung sichtbar, und zwar unabhängig davon, welcher Spannungswert in der vorangehenden Haltephase in den Speicherkondensatoren C4 und C5 gespeichert waren.

Die in Fig. 4 gezeigte Abtast-Halte-Einrichtung kann beispielsweise in der in Fig. 2 und 3 gezeigten Analog-Digital-Wandlereinheit 4 eingesetzt werden.

Die beschriebenen integrierten Schaltung und Abtast-Halte-Einrichtungen können beispielsweise in Bipolartechnik, CMOS-Technik oder auch BiCMOS-Technik realisiert werden, wobei die erwähnten Schalter durch Transistoren realisiert werden können.

Bei den beschriebenen Ausführungsformen werden die Speichereinrichtungen sowie die Rücksetzeinrichtungen jeweils kapazitiv verwirklicht. Es ist jedoch auch eine induktive Verwirklichung möglich, wobei dann anstatt der Kondensatoren Spulen bzw. Induktivitäten eingesetzt werden und nicht Spannungswerte sondern Stromwerte gespeichert werden. Die genaue Ausgestaltung mit Spulen bzw. Induktivitäten kann der Fachmann leicht durchführen.

## Patentansprüche

1. Integrierte Schaltung mit einer Abtast-Halte-Einrichtung, die eine Eingangsstufe (OP1; OP11; 10) mit einem Eingang, an den ein analoges Eingangssignal (Vi) anlegbar ist, und einem Ausgang, eine erste kapazitive Speichereinrichtung (C1; C11; C4), sowie eine Schalteinrichtung (S1; S11; S12) umfaßt, wobei die Abtast-Halte-Einrichtung in aufeinanderfolgenden Zyklen mit jeweils einer Abtastphase und einer Haltephase betreibbar ist, wobei die Schalteinrichtung (S1; S11; S12) in der Abtastphase die erste Speichereinrichtung (C1; C11; C4) mit dem Ausgang der Eingangsstufe verbindet, um in der ersten Speichereinrichtung (C1; C11; C12) einen zum angelegten Eingangssignal proportionalen Spannungswert zu speichern, und in der Haltephase die erste Speichereinrichtung (C; C11; C12) vom Ausgang der Eingangsstufe (OP1; OP11; 10) trennt, um den gespeicherten Spannungswert für einen weiteren Schaltungsteil der integrierten Schaltung bereit zu stellen, so daß die erste Speichereinrichtung (C1; C11; C4) am Ende der Haltephase einen Endspannungswert speichert, **dadurch gekennzeichnet, daß** die Abtast-Halte-Einrichtung zusätzlich eine Rücksetzeinrichtung (4; 14; C3; C31; C6) umfaßt, wobei die Rücksetzeinrichtung (4; 14; C3; C31; C6) eine zweite kapazitive Speichereinrichtung (C3; C31; C6) mit gleicher Kapazität wie die erste Speichereinrichtung (C1; C11; C4) sowie eine Steuerschaltung (4; 14) aufweist, wobei die Steuerschaltung (4; 14) ein Laden der zweiten Speichereinrichtung (C3 ; C31; C6) während eines ersten Zyklus auf einen Spannungswert bewirkt, der zum Endspannungswert bezüglich einer Referenzspannung (Vref) invertiert ist, und in der Abtastphase des auf den ersten Zyklus folgenden zweiten Zyklus die zweite Speichereinrichtung (C3; C31; C6) mit der ersten Speichereinrichtung (C1; C11; C4) verbindet, um die erste Speichereinrichtung (C1; C11; C4) zu entladen.

2. Integrierte Schaltung nach Anspruch 1, bei der die Steuerschaltung (4; 14) zum Laden der zweiten Speichereinrichtung (C3; C31; C6) die zweite Speichereinrichtung (C3; C31; C6) während der Abtastphase des ersten Zyklus mit einer Spannung beaufschlagt, die zu einer Spannung, mit der die erste Speichereinrichtung (C1; C11; C4) während der Abtastphase beaufschlagt wird, bezüglich der Referenzspannung (Vref) invertiert ist.

3. Integrierte Schaltung nach Anspruch 1 oder 2, bei dem die Steuerschaltung (4; 14) zum Läden der zweiten Speichereinrichtung (C3; C31; C6) die zweite Speichereinrichtung (C3; C31; C6) während der Haltephase des ersten Zyklus mit einer Spannung beaufschlagt, die zu einer Spannung, mit der die erste Speichereinrichtung (C1; C11; C4) während der Haltephase beaufschlagt wird, bezüglich der Referenzspannung (Vref) invertiert ist.

4. Integrierte Schaltung nach einem der obigen Ansprüche, bei der die Steuerschaltung (4; 14) ein Laden der zweiten Speichereinrichtung (C3; C31; C6) während des zweiten und der nachfolgenden Zyklen jeweils auf einen Spannungswert bewirkt, der zum Endspannungswert der ersten Speichereinrichtung (C1; C11; C4) dieses Zyklus bezüglich der Referenzspannung (Vref) invertiert ist, und in der Abtastphase des dritten bzw. der weiteren Zyklen die zweite Speichereinrichtung (C3; C31; C6) mit der ersten Speichereinrichtung (C1; C11; C4) verbindet.

5. Integrierte Schaltung nach einem der obigen Ansprüche, bei der die erste Speichereinrichtung (C1) und die zweite Speichereinrichtung (C3) jeweils einen Kondensator (C1; C3) aufweisen, die beim Verbinden während der Abtastphase des zweiten Zyklus parallel geschaltet werden.

6. Integrierte Schaltung nach einem der obigen Ansprüche, wobei die integrierte Schaltung als Analog-Digital-Wandler ausgebildet ist.

7. Integrierte Schaltung nach einem der obigen Ansprüche, bei der die erste Speichereinrichtung einen ersten und einen zweiten Kondensator (C11; C4; C12; C5) und die zweite Speichereinrichtung einen dritten und einen vierten Kondensator (C31; C6; C32; C7) umfaßt, wobei der erste und der dritte Kondensator (C11; C4; C31; C6) sowie der zweite und der vierte Kondensator (C21; C5; C32; C7) jeweils die gleiche Kapazität aufweisen, wobei die Eingangsstufe einen Differenzverstärker (10) umfaßt, an den ein analoges Eingangssignal anlegbar ist und dessen Ausgang einen invertierenden und einen nicht-invertierenden Ausgangsanschluß (12; 13) aufweist, wobei die Schalteinrichtung in der Abtastphase den ersten Kondensator (C11; C4) mit dem nicht-invertierenden Ausgangsanschluß (12) und den zweiten Kondensator (C12; C5) mit dem invertierenden Ausgangsanschluß (13) verbindet, wobei die Steuerschaltung (4; 14) zum Laden während des ersten Zyklus bewirkt, daß der dritte Kondensator (C31; C6) auf einen Spannungswert, der zum Endspannungswert des ersten Kondensators (C11; C4) bezüglich der Referenzspannung (Vref) invertiert ist, und der vierte Kondensator (C32; C7) auf einen Spannungswert geladen werden, der zum Endspannungswert des zweiten Kondensators (C12; C5) bezüglich der Referenzspannung (Vref) invertiert ist, und wobei in der Abtastphase des zweiten Zyklus die Steuerschaltung (4; 14) den ersten Kondensator (C11; C4) mit dem dritten Kondensator (C31; C6) sowie den zweiten Kondensator (C12; C5) mit dem vierten. Kondensator (C32; C7) verbindet.

8. Integrierte Schaltung nach Anspruch 7, bei der die Steuerschaltung (14) in Abtastphasen von geradzahligen Zyklen den dritten Kondensator (6) parallel zum ersten Kondensator (C4) sowie den vierten Kondensator (C7) parallel zum zweiten Kondensator (C5) schaltet und in Abtastphasen von ungeradzahligen Zyklen den dritten Kondensator (C6) parallel zum zweiten Kondensator (5) sowie den vierten Kondensator (C7) parallel zum ersten Kondensator (4) schaltet.

9. Integrierte Schaltung nach einem der obigen Ansprüche, bei der die erste und zweite Speichereinrichtung jeweils die gleiche Anzahl von während der Abtastphase parallel geschalteten Kondensatoren mit gleicher Kapazität aufweisen.

10. Integrierte Schaltung mit einer Abtast-Halte-Einrichtung, die eine Eingangsstufe mit einem Eingang, an den ein analoges Eingangssignal anlegbar ist, und einem Ausgang, eine erste Speichereinrichtung, sowie eine Schalteinrichtung umfaßt, wobei die Abtast-Halte-Einrichtung in aufeinanderfolgenden Zyklen mit jeweils einer Abtastphase und einer Haltephase betreibbar ist, wobei die Schalteinrichtung in der Abtastphase die erste Speichereinrichtung mit dem Ausgang der Eingangsstufe verbindet, um in der ersten Speichereinrichtung einen zum angelegten Eingangssignal proportionalen Stromwert zu speichern, und in der Haltephase die erste Speichereinrichtung vom Ausgang der Eingangsstufe trennt, um den gespeicherten Stromwert für einen weiteren Schaltungsteil der integrierten Schaltung bereit zu stellen, so daß die erste Speichereinrichtung am Ende der Haltephase einen Endstromwert speichert, **dadurch gekennzeichnet, daß**
die erste Speichereinrichtung inducktiv ist, und daß die Abtast-Halte-Einrichtung eine Rücksetzeinrichtung umfaßt, wobei die Rücksetzeinrichtung eine zweite induktive Speichereinrichtung mit gleicher Induktivität wie die erste Speichereinrichtung sowie eine Steuerschaltung aufweist, wobei die Steuerschaltung ein Laden der zweiten Speichereinrichtung während eines ersten Zyklus auf einen Stromwert bewirkt, der zum Endstromwert bezüglich eines Referenzstroms invertiert ist, und in der Abtastphase des auf den ersten Zyklus folgenden zweiten Zyklus die zweite Speichereinrichtung mit der ersten Speichereinrichtung verbindet, um die erste Speichereinrichtung zu entladen.

## Claims

1. Integrated circuit having a sample-and-hold device, which comprises an input stage (OP1; OP11; 10) having an input, to which an analogue input signal (Vi) can be applied, and an output, a first capacitive storage device (C1; C11; C4), and also a switching device (S1; S11; S12), it being possible to operate the sample-and-hold device in successive cycles with in each case a sample phase and a hold phase, in the sample phase the switching device (S1; S11; S12) connecting the first storage device (C1; C11; C4) to the output of the input stage in order to store a voltage value proportional to the applied input signal in the first storage device (C1; C11; C12), and in the hold phase the switching device isolating the first storage device (C; C11; C12) from the output of the input stage (OP1; OP11; 10) in order to provide the stored voltage value for a further circuit part of the integrated circuit, so that the first storage device (C1; C11; C4) stores a final voltage value at the end of the hold phase, **characterized in that** the sample-and-hold device additionally comprises a reset device (4; 14; C3; C31; C6), the reset device (4; 14; C3; C31; C6) having a second capacitive storage device (C3; C31; C6) having the same capacitance as the first storage device (C1; C11; C4) and also a control circuit (4; 14), the control circuit (4; 14) effecting a charging of the second storage device (C3; C31; C6) during a first cycle to a voltage value which is inverted with respect to the final voltage value with regard to a reference voltage (Vref), and, in the sample phase of the second cycle following the first cycle, said control circuit connecting the second storage device (C3; C31; C6) to the first storage device (C1; C11; C4) in order to discharge the first storage device (C1; C11; C4).

2. Integrated circuit according to Claim 1, in which, for the purpose of charging the second storage device (C3; C31; C6), the control circuit (4; 14) applies to the second storage device (C3; C31; C6) during the sample phase of the first cycle a voltage which is inverted with respect to a voltage applied to the first storage device (C1; C11; C4) during the sample phase, with regard to the reference voltage (Vref).

3. Integrated circuit according to Claim 1 or 2, in which, for the purpose of charging the second storage device (C3; C31; C6), the control circuit (4; 14) applies to the second storage device (C3; C31; C6) during the hold phase of the first cycle a voltage which is inverted with respect to a voltage applied to the first storage device (C1; C11; C4) during the hold phase, with regard to the reference voltage (Vref).

4. Integrated circuit according to one of the preceding claims, in which the control circuit (4; 14) effects a charging of the second storage device (C3; C31; C6) during the second and the subsequent cycles in each case to a voltage value which is inverted with respect to the final voltage value of the first storage device (C1; C11; C4) of this cycle with regard to the reference voltage (Vref), and, in the sample phase of the third and respectively the further cycles, said control circuit connects the second storage device (C3; C31; C6) to the first storage device (C1; C11; C4).

5. Integrated circuit according to one of the preceding claims, in which the first storage device (C1) and the second storage device (C3) in each case have a capacitor (C1; C3), which are connected in parallel in the event of the connection during the sample phase of the second cycle.

6. Integrated circuit according to one of the preceding claims, in which the integrated circuit is formed as an analogue-to-digital converter.

7. Integrated circuit according to one of the preceding claims, in which the first storage device comprises a first and a second capacitor (C11; C4; C12; C5) and the second storage device comprises a third and a fourth capacitor (C31; C6; C32; C7), the first and third capacitors (C11; C4; C31; C6) and also the second and fourth capacitors (C21; C5; C32; C7) in each case having the same capacitance, the input stage comprising a differential amplifier (10), to which an analogue input signal can be applied and the output of which has an inverting and a non-inverting output terminal (12; 13), in the sample phase the switching device connecting the first capacitor (C11; C4) to the non-inverting output terminal (12) and the second capacitor (C12; C5) to the inverting output terminal (13), the control circuit (4; 14), for the purpose of charging during the first cycle, having the effect that the third capacitor (C31; C6) is charged to a voltage value which is inverted with respect to the final voltage value of the first capacitor (C11; C4) with regard to the reference voltage (Vref) and the fourth capacitor (C32; C7) is charged to a voltage value which is inverted with respect to the final voltage value of the second capacitor (C12; C5) with regard to the reference voltage (Vref), and in the sample phase of the second cycle the control circuit (4; 14) connecting the first capacitor (C11; C4) to the third capacitor (C31; C6) and the second capacitor (C12; C5) to the fourth capacitor (C32; C7).

8. Integrated circuit according to Claim 7, in which in sample phases of even-numbered cycles the control circuit (14) connects the third capacitor (6) in parallel with the first capacitor (C4) and the fourth capacitor (C7) in parallel with the second capacitor (C5) and in sample phases of odd-numbered cycles said control circuit connects the third capacitor (C6) in parallel with the second capacitor (5) and the fourth capacitor (C7) in parallel with the first capacitor (4).

9. Integrated circuit according to one of the preceding claims, in which the first and second storage device in each case have the same number of capacitors having the same capacitance that are connected in parallel during the sample phase.

10. Integrated circuit having a sample-and-hold device, which comprises an input stage having an input, to which an analogue input signal can be applied, and an output, a first storage device, and also a switching device, it being possible to operate the sample-and-hold device in successive cycles with in each case a sample phase and a hold phase, in the sample phase the switching device connecting the first storage device to the output of the input stage in order to store a current value proportional to the applied input signal in the first storage device, and in the hold phase the switching device isolating the first storage device from the output of the input stage in order to provide the stored current value for a further circuit part of the integrated circuit, so that the first storage device stores a final current value at the end of the hold phase, **characterized in that** the first storage device is inductive and **in that** the sample-and-hold device comprises a reset device, the reset device having a second inductive storage device having the same inductance as the first storage device and also a control circuit, the control circuit effecting a charging of the second storage device during a first cycle to a current value which is inverted with respect to the final current value with regard to a reference current, and, in the sample phase of the second cycle following the first cycle, said control circuit connecting the second storage device to the first storage device in order to discharge the first storage device.

## Revendications

1. Circuit intégré comprenant un dispositif échantillonneur-bloqueur qui a un étage (OP1 ; OP11 ; 10) d'entrée ayant une entrée sur laquelle peut être appliqué un signal (Vi) d'entrée et une sortie, un premier dispositif (C1 ; C11 ; C4) capacitif de mémoire, ainsi qu'un dispositif (S1 ; S11 ; S12) de commutation, le dispositif échantillonneur-bloqueur pouvant fonctionner en des cycles successifs ayant respectivement une phase d'échantillonnage et une phase de blocage, le dispositif (S1; S11 ; S12) de commutation reliant, dans la phase d'échantillonnage, le premier dispositif (C1 ; C11 ; C4) de mémoire à la sortie de l'étage d'entrée pour mémoriser dans le premier dispositif (C1 ; C11 ; C12) de mémoire une valeur de tension proportionnelle au signal d'entrée appliqué et séparant, dans la phase de blocage, le premier dispositif (C1; C11 ; C12) de mémoire de la sortie de l'étage (OP1 ; OP11 ; 10) d'entrée pour mettre à disposition la valeur de tension mémorisée pour une autre partie du circuit intégré, de sorte que le premier dispositif (C1 ; C11 ; C4) de mémoire mémorise une valeur de tension finale à la fin de la phase de blocage, **caractérisé en ce que** le dispositif échantillonneur-bloqueur comprend, en outre, un dispositif (4 ; 14 ; C3 ; C31 ; C6) de remise à l'état initial, le dispositif (4 ; 14 ; C3 ; C31 ; C6) de remise en l'état initial ayant un deuxième dispositif (C3 ; C31 ; C6) capacitif de mémoire de même capacité que le premier dispositif (C1 ; C11 ; C4) de mémoire, ainsi qu'un circuit (4 ; 14) de commande, le circuit (4 ; 14) de commande provoquant un chargement du deuxième dispositif (C3 ; C31 ; C6) de mémoire pendant un premier cycle jusqu'à une valeur de tension qui est l'inverse de la valeur de tension finale par rapport à une tension (Vref) de référence et, dans la phase de blocage du deuxième cycle suivant le premier cycle, reliant le deuxième dispositif (C3 ; C31 ; C6) de mémoire au premier dispositif (C1 ; C11 ; C4) de mémoire pour décharger le premier dispositif (C1 ; C11 ; C4) de mémoire.

2. Circuit intégré suivant la revendication 1, dans lequel le circuit (4 ; 14) de commande alimente, pour le chargement du deuxième dispositif (C3 ; C31 ; C6) de mémoire, le deuxième dispositif (C3 ; C31 ; C6) de mémoire pendant la phase d'échantillonnage du premier cycle en une tension qui est l'inverse, par rapport à la tension (Vref) de référence, d'une tension avec laquelle le premier dispositif (C1 ; C11 ; C4) de mémoire est alimenté pendant la phase d'échantillonnage.

3. Circuit intégré suivant la revendication 1 ou 2, dans lequel le circuit (4 ; 14) de commande alimente, pour le chargement du deuxième dispositif (C3 ; C31 ; C6) de mémoire, le deuxième dispositif (C3 ; C31 ; C6) de mémoire pendant la phase de blocage du premier cycle en une tension qui est l'inverse, par rapport à la tension (Vref) de référence, d'une tension avec laquelle le premier dispositif (C1 ; C11 ; C4) de mémoire est alimenté pendant la phase de blocage.

4. Circuit intégré suivant l'une des revendications précédentes, dans lequel le circuit (4 ; 14) de commande provoque un chargement du deuxième dispositif (C3 ; C31 ; C6) de mémoire pendant le deuxième cycle et les cycles suivants respectivement, jusqu'à une valeur de tension qui est l'inverse, par rapport à la tension (Vref) de référence, d'une valeur de tension finale du premier dispositif (C1 ; C11 ; C4) de mémoire de ce cycle et, dans la phase d'échantillonnage du troisième cycle et des autres cycles, relie le deuxième dispositif (C3 ; C31 ; C6) de mémoire au premier dispositif (C1 ; C11 ; C4) de mémoire.

5. Circuit intégré suivant l'une des revendications ci-dessus, dans lequel le premier dispositif (C1) de mémoire et le deuxième dispositif (C3) de mémoire ont respectivement un condensateur (C1 ; C3) qui, lors de la liaison pendant la phase d'échantillonnage du deuxième cycle, sont montés en parallèle.

6. Circuit intégré suivant l'une des revendications ci-dessus, dans lequel le circuit intégré est constitué en convertisseur analogique-numérique.

7. Circuit intégré suivant l'une des revendications ci-dessus, dans lequel le premier dispositif de mémoire comprend un premier et un deuxième condensateur (C11 ; C4 ; C12 ; C5) et le deuxième dispositif de mémoire comprend un troisième et un quatrième condensateur (C31 ; C6 ; C32 ; C7), le premier et le troisième condensateur (C11 ; C4 ; C31 ; C6) ainsi que le deuxième et le quatrième condensateur (C21 ; C5 ; C32 ; C7) ayant respectivement la même capacité, l'étage d'entrée comprenant un amplificateur (10) différentiel auquel peut être appliqué un signal analogique d'entrée et dont la sortie a une borne (12) de sortie inverseuse et une borne (13) de sortie non inverseuse, le circuit de commutation reliant, dans la phase d'échantillonnage, le premier condensateur (C11 ; C4) à la borne (12) de sortie non inverseuse et le deuxième condensateur (C12 ; C5) à la borne (13) de sortie inverseuse, le circuit (4 ; 14) de commande faisant que, pendant le premier cycle, le troisième condensateur (C31 ; C6) est chargé jusqu'à une valeur de tension qui est l'inverse, par rapport à la tension (Vref) de référence, de la valeur de tension finale du premier condensateur (C11 ; C4), et le quatrième condensateur (C32 ; C7) étant chargé jusqu'à une valeur de tension qui est l'inverse, par rapport à la tension (Vref) de référence, de la valeur de tension finale du deuxième condensateur (C12 ; C5) et dans lequel, dans la phase d'échantillonnage du deuxième cycle, le circuit (4 ; 14) de commande du premier condensateur (C11 ; C4) relie le premier condensateur (C11 ; C4) au troisième condensateur (C31 ; C6), ainsi que le deuxième condensateur (C12 ; C5) au quatrième condensateur (C32 ; C7).

8. Circuit intégré suivant la revendication 7, dans lequel le circuit (14) de commande branche, dans des phases d'échantillonnage de cycles pairs, le troisième condensateur (6) en parallèle au premier condensateur (C4), ainsi que le quatrième condensateur (C7) en parallèle au deuxième condensateur (C5), et dans des phases d'échantillonnage de cycle impair, le troisième condensateur (C6) en parallèle au deuxième condensateur (C5), ainsi que le quatrième condensateur (C7) en parallèle au premier condensateur (4).

9. Circuit intégré suivant l'une des revendications ci-dessus, dans lequel le premier et le deuxième dispositif de mémoire ont respectivement le même nombre de condensateurs de même capacité montés en parallèle pendant la phase d'échantillonnage.

10. Circuit intégré comprenant un dispositif échantillonneur-bloqueur qui a un étage d'entrée ayant une entrée sur laquelle peut être appliqué un signal d'entrée et une sortie, un premier dispositif capacitif de mémoire, ainsi qu'un dispositif de commutation, le dispositif échantillonneur-bloqueur pouvant fonctionner en des cycles successifs ayant respectivement une phase d'échantillonnage et une phase de blocage, le dispositif de commutation reliant, dans la phase d'échantillonnage, le premier dispositif de mémoire à la sortie de l'étage d'entrée pour mémoriser dans le premier dispositif de mémoire une valeur de courant proportionnelle au signal d'entrée appliqué et séparant, dans la phase de blocage, le premier dispositif de mémoire de la sortie de l'étage d'entrée pour mettre à disposition la valeur de courant mémorisée pour une autre partie du circuit intégré, de sorte que le premier dispositif de mémoire mémorise une valeur de courant finale à la fin de la phase de blocage, **caractérisé en ce que** le premier dispositif de mémoire est inductif et **en ce que** le dispositif échantillonneur-bloqueur comprend un dispositif de remise à l'état initial, le dispositif de remise à l'état initial ayant un deuxième dispositif inductif de mémoire de même inductance que le premier dispositif de mémoire ainsi qu'un circuit de commande, le circuit de commande provoquant un chargement du deuxième dispositif de mémoire pendant un premier cycle jusqu'à une valeur de courant qui est l'inverse, par rapport à un courant de référence, de la valeur de courant finale et, dans la phase d'échantillonnage du deuxième cycle suivant le premier cycle, relie le deuxième dispositif de mémoire au premier dispositif de mémoire pour décharger le premier dispositif de mémoire.
